# EUROPEAN PATENT APPLICATION

(11) **EP 2 076 101 A1**
(43) Date of publication of application: **01.07.2009**
(21) Application number: 08163266.3
(22) Date of filing: 29.08.2008
(51) Int. Cl.: H05K 1/03

(54) **Printed wiring board and printed circuit board unit**

(30) Priority: 28.12.2007 JP 2007339306
(71) Applicant: Fujitsu Ltd., Kawasaki-shi, Kanagawa 211-8588 (JP)
(72) Inventor: Morita, Yoshihiro, Kawasaki-shi, Kanagawa 211-8588 (JP)
(74) Representative: Wilding, Frances Ward

(57) **Abstract**

A printed wiring board includes a body made of resin. Woven glass fiber yarns are impregnated in the resin of the body. An electrically-conductive wiring pattern is formed on the surface of the body. The wiring pattern extends in parallel with the glass fiber yarns. The width of the wiring pattern is set equal to or larger than the interval between the centerlines of the adjacent ones of the glass fiber yarns extending in parallel. The wiring pattern is reliably located in a region containing both the glass fiber and the resin. The proportion of the glass fiber to the resin is equalized on the wiring patterns. This results in a suppression of the influence resulting from a difference in the permittivity between the glass fiber and the resin on the wiring pattern. A variation of characteristic impedance is suppressed with such a simplified structure.

## Description

### BACKGROUND OF THE INVENTION

### Field of the Invention:

The present invention relates to a printed wiring board preferably utilized for transmission of differential signals, for example.

### Description of the Prior Art:

A relay unit is utilized for establishment of a trunk communication network, for example. A printed circuit board unit is incorporated in the relay unit. In the printed circuit board unit, large-scale integrated circuit (LSI) chips are mounted on the surface of a printed wiring board. The LSI chips are connected to each other through a pair of wiring patterns extending within the printed wiring board, for example. The wiring patterns are spaced from each other at a predetermined interval. Transmission of a differential signal is established between the LSI chips.

The printed wiring board is made of resin. Glass fiber cloth is impregnated in the resin of the printed wiring board. The glass fiber cloth is woven from warp yarns and weft yarns. The aforementioned wiring patterns are designed to extend in parallel with the warp yarns, for example. Gaps are defined between adjacent ones of the warp yarns. The gaps are filled with the resin. When one of the wiring patterns is opposed to the gaps or resin over a relatively large area, for example, the other wiring pattern is opposed to the warp yarns over a relatively large area.

The permittivity of a resin mass is different from that of glass fiber yarns. When the proportion of the glass to the resin opposed to one of the wiring patterns is different from the proportion of the glass to the resin opposed to the other of the wiring patterns, the characteristic impedance of one of the wiring patterns gets unequal to that of the other of the wiring patterns. This results in a difference of the transmission speed of differential signals. When signals are transmitted based on a differential voltage, for example, such a difference in the transmission speed causes a time lag of change in voltage at the LSI chip of the receiving side. Signals thus cannot accurately be transmitted.

### SUMMARY OF THE INVENTION

It is desirable to provide a printed wiring board and a printed circuit board unit contributing to suppression of the influence resulting from a difference in permittivity with a simplified structure.

According to embodiments of the present invention, there is provided a printed wiring board comprising: a body made of resin; woven glass fiber yarns impregnated in the resin of the body; and a wiring pattern formed on the surface of the body, the wiring pattern extending in parallel with the glass fiber yarns, the wiring pattern made of an electrically-conductive material, wherein the width of the wiring pattern is set equal to or larger than the interval between the centerlines of the adjacent ones of the glass fiber yarns extending in parallel.

The printed wiring board includes the glass fiber yarns impregnated in the resin. Spaced between the glass fiber yarns are thus filled with the resin. Since the width of the wiring pattern is set equal to or larger than the interval between the centerlines of the adjacent ones of the glass fiber yarns, the wiring pattern is reliably located in a region containing both the glass fiber and the resin. The proportion of the glass fiber to the resin on the wiring pattern is thus equalized as much as possible. This results in a suppression of the influence resulting from a difference in the permittivity between the glass fiber and the resin on the wiring pattern. A variation of characteristic impedance is suppressed with such a simplified structure.

When the width of the wiring pattern is set smaller than the aforementioned interval, for example, the wiring pattern cannot be located on both the glass fiber and the resin. The influence of a difference in the permittivity between the glass fiber and the resin on the wiring pattern is thus significantly increased. A variation in characteristic impedance is inevitable.

In the printed wiring board, the width of the aforementioned wiring pattern is set equal to or larger than the interval between the centerlines of two outer ones of adjacent three of the glass fiber yarns extending in parallel one another. When the width of the wiring pattern is set equal to or larger than the interval between the centerlines of two outer ones of adjacent three of the fiber yarns extending in parallel one another, the wiring pattern is located on at least two glass fiber yarns. The influence of a difference in the permittivity between the glass fiber and the resin is further suppressed as compared with the aforementioned wiring pattern. A variation in characteristic impedance is further reduced. In addition, as the width of the wiring pattern is larger, the wiring pattern is located on a larger amount of the glass fiber and resin. A further increase in the width of the wiring pattern thus allows a further suppression of the influence resulting from a difference in the permittivity between the glass fiber and the resin.

In the printed wiring board, the width of the aforementioned wiring pattern is set equal to the integer times of the interval between the centerlines of the adjacent ones of the glass fiber yarns. The proportion of the glass fiber to the resin on the wiring pattern is thus reliably equalized irrespective of the position of the wiring pattern relative to the glass fiber yarns. The influence of a difference in the permittivity between the glass fiber and the resin is in this manner eliminated with a simplified structure. A variation of characteristic impedance is reliably prevented.

The printed wiring board is incorporated in a printed circuit board unit. The printed circuit board unit comprises: a body made of resin; woven glass fiber yarns impregnated in the resin of the body; a wiring pattern formed on the surface of the body, the wiring pattern extending in parallel with the glass fiber yarns, the wiring pattern made of an electrically-conductive material; and a pair of electronic components located on the surface of the body, the electronic components connected to each other through the wiring pattern. The width of the wiring pattern is set equal to or larger than the interval between the centerlines of the adjacent ones of the glass fiber yarns extending in parallel.

The printed circuit board unit is allowed to enjoy the aforementioned advantages. Signals are thus transmitted between the electronic components with accuracy, for example. The width of the wiring pattern is set equal to or larger than the interval between the centerlines of two outer ones of adjacent three of the glass fiber yarns extending in parallel one another, in the same manner as described above. Otherwise, the width of the wiring pattern is set equal to the integer times of the interval between the centerlines of the adjacent ones of the glass fiber yarns.

### BRIEF DESCRIPTION OF THE DRAWINGS

The above and other objects, features and advantages of the present invention will become apparent from the following description of the preferred embodiments in conjunction with the accompanying drawings, wherein:
Fig. 1 is a perspective view schematically illustrating the structure of a transmission unit as an example of an electronic apparatus;
Fig. 2 is a perspective view schematically illustrating the structure of a printed circuit board unit according to an embodiment of the present invention;
Fig. 3 is an enlarged partial sectional view taken along the line 3-3 in Fig. 2, for schematically illustrating a printed wiring board according to a first embodiment of the preset invention;
Fig. 4 is a sectional view taken along the line 4-4 in Fig. 3;
Fig. 5 is an enlarged partial sectional view taken along the line 5-5 in Fig. 2;
Fig. 6 is an enlargedpartial sectional view, corresponding to Fig. 4, schematically illustrating a printed wiring board according to a second embodiment of the present invention; and
Fig. 7 is an enlarged partial sectional view, corresponding to Fig. 4, schematically illustrating a printed wiring board according to a third embodiment of the present invention.

### DESCRIPTION OF THE PREFERRED EMBODIMENTS

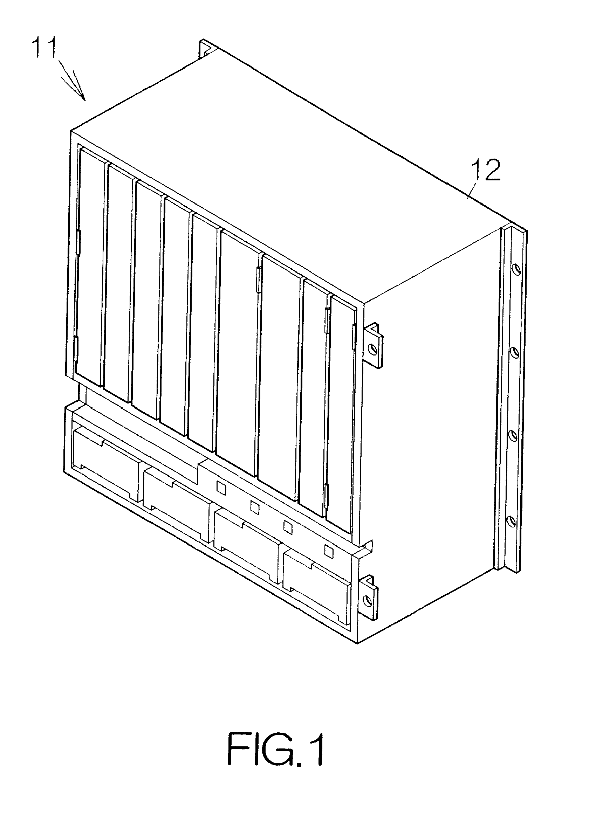

Fig. 1 is a perspective view schematically illustrating a transmission unit 11 as an example of an electronic apparatus. The transmission unit 11 is incorporated in a dense wavelength division multiplexing (DWDM) communication system, for example. The transmission unit 11 is mounted on a rack, for example. The transmission unit 11 includes an enclosure 12. A printed circuit board unit or motherboard according to the present invention is incorporated in an inner space defined in the enclosure 12.

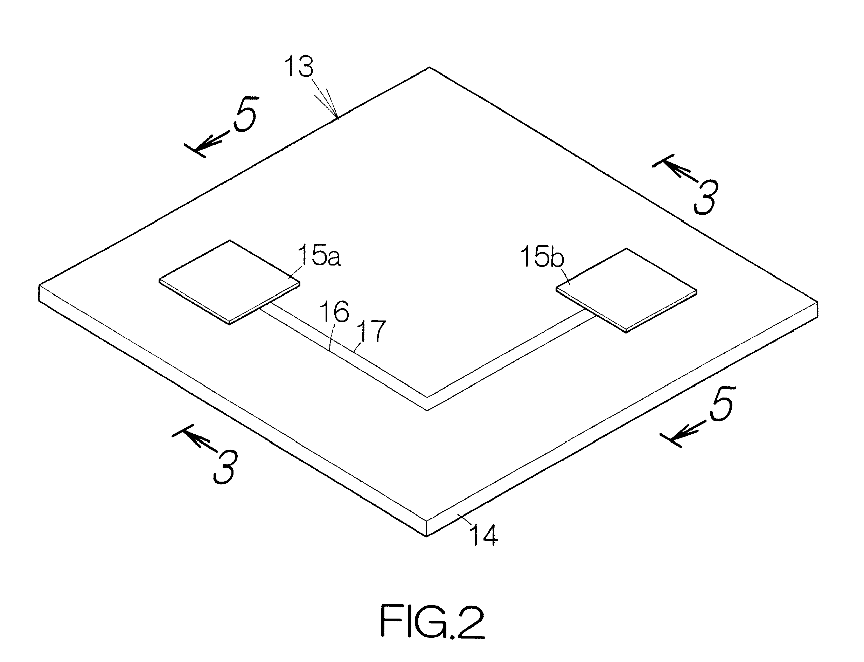

Fig. 2 schematically illustrates a motherboard 13 according to an embodiment of the present invention. The motherboard 13 includes a large-sized printed wiring board 14, for example. A pair of electronic components, namely first and second large-scale integrated circuit (LSI) chip packages 15a, 15b, are mounted on the surface of the printed wiring board 14, for example. A ball grid array (BGA) is utilized to fix the first and second LSI chip packages 15a, 15b to the printed wiring board 14, for example.

The first and second LSI chip packages 15a, 15b are electrically connected to each other through linear first and second wiring patterns 16, 17, for example. Transmission of a differential signal is established between the first and second LSI chip packages 15a, 15b based on a differential voltage, for example. The first and second wiring patterns 16, 17 are designed to extend side by side within the printed wiring board 14, for example. The first and second wiring patterns 16, 17 are bent at a right angle, for example.

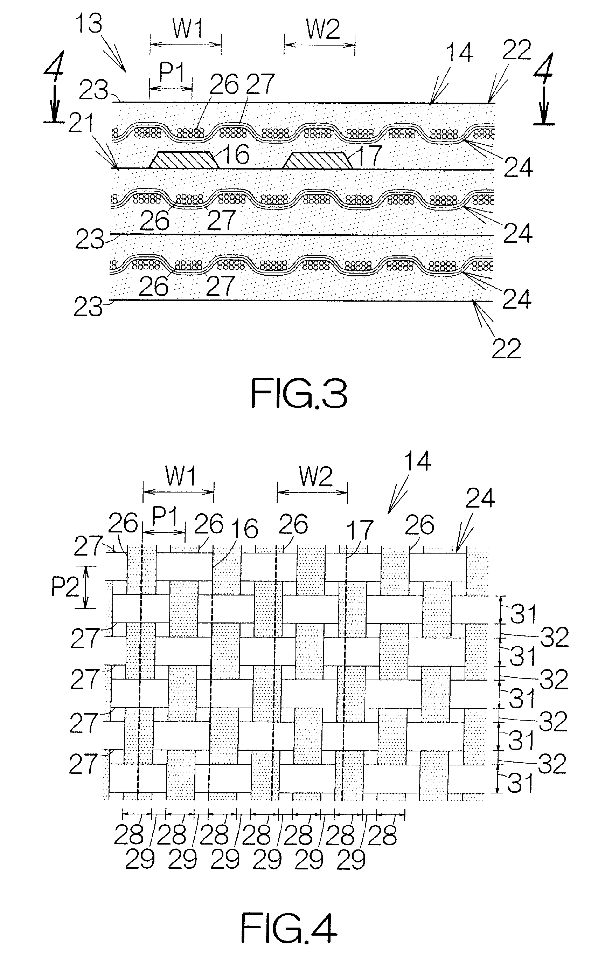

Fig. 3 schematically illustrates the printed wiring board 14 according to a first embodiment of the present invention. The printed wiring board 14 includes a core resin layer 21. Insulating layers 22 are formed on the front and back surfaces of the core resin layer 21, respectively. The core resin layer 21 and the insulating layers 22 each include a body 23 made of resin such as an epoxy resin, for example. The core resin layer 21 has rigidity sufficient to maintain its shape by itself. The core resin layer 21 and the insulating layers 22 each have a thickness of 100µm to 200µm approximately, for example.

A glass fiber cloth 24 is embedded within the body 23. The glass fiber cloth 24 has a thickness of 30µm approximately, for example. Referring also to Fig. 4, the glass fiber cloth 24 is woven from warp yarns 26 extending in parallel one another and weft yarns 27 extending in parallel one another. Here, the warp yarns 26 intersect with the weft yarns 27 at right angles. The warp yarns 26 are arranged at equal intervals. Likewise, the weft yarns 27 are arranged at equal intervals.

The centerlines of adjacent ones of the parallel warp yarns 26 are spaced from each other at an interval *P1*. The interval *P1* is set at 50µm to 100µm approximately, for example. The centerlines of adjacent ones of the parallel weft yarns 27 are spaced from each other at an interval *P2*. The interval *P2* is also set at 50µm to 100µm approximately, for example. Here, the interval *P2* is set equal to the interval *P1*. The interval *P1* and the interval *P2* are uniformly set not only in the core resin layer 21 but also in the insulating layers 22.

The warp yarns 26 and the weft yarns 27 are made of glass fiber yarns. Here, a single warp yarn 26 and a single weft yarn 27 is a bundle of glass fiber. Alternatively, a single warp yarn 26 and a single weft yarn 27 may be a single glass fiber. The glass fiber cloth 24 may be impregnated in resin so as to provide the core resin layer 21 and the insulating layers 22. Description will be made on a method of making the printed wiring board 14 later in detail.

As is apparent from Fig. 4, in the printed wiring board 14, the individual warp yarn 26 is located in a first region 28. The first region 28 thus has a relatively large amount of glass fiber. The width of the first region 28 corresponds to the width of the warp yarn 26. Second regions 29 are located at positions adjacent to the corresponding first regions 28. The individual second region 29 corresponds to a gap between adjacent ones of the warp yarns 26. Since no warp yarn 29 is located in the second region 29, the second region 29 has a relatively large amount of resin. The first regions 28 and the second regions 29 are alternately defined.

Likewise, in the printed wiring board 14, the individual weft yarn 27 is located in a first region 31. The first region 31 thus has a relatively large amount of glass fiber. The width of the first region 31 is defined by the width of the weft yarn 27. Second regions 32 are located at positions adjacent to the first regions 31. The individual second region 32 is defined by a gap between adjacent ones of the weft yarns 27. Since no weft yarn 27 is located in the second region 32, the second region 32 has a relatively large amount of resin. The first regions 31 and the second regions 32 are alternately defined.

The aforementioned first and second wiring patterns 16, 17 are formed on the surface of the core resin layer 21, for example. The first and second wiring patterns 16, 17 are made of an electrically-conductive material such as copper, for example. The first and second wiring patterns 16, 17 extend in parallel with the weft yarns 26. The first and second wiring patterns 16, 17 have the same length between the first and second LSI chip packages 15a, 15b.

The width *W1* of the first wiring pattern 16 and the width *W2* of the second wiring pattern 17 are set equal to or larger than the aforementioned interval *P1*. The width *W1* is set equal to the width *W2*. According to the present embodiment, the interval *P1* is set at 100µm approximately, for example. The width *W1* and the width *W2* are set at 150µm approximately, for example. The first and second wiring patterns 16, 17 each have a thickness of 35µm approximately, for example. Each of the first and second wiring patterns 16, 17 is in this manner reliably located in a region containing both the first and second regions 28, 29.

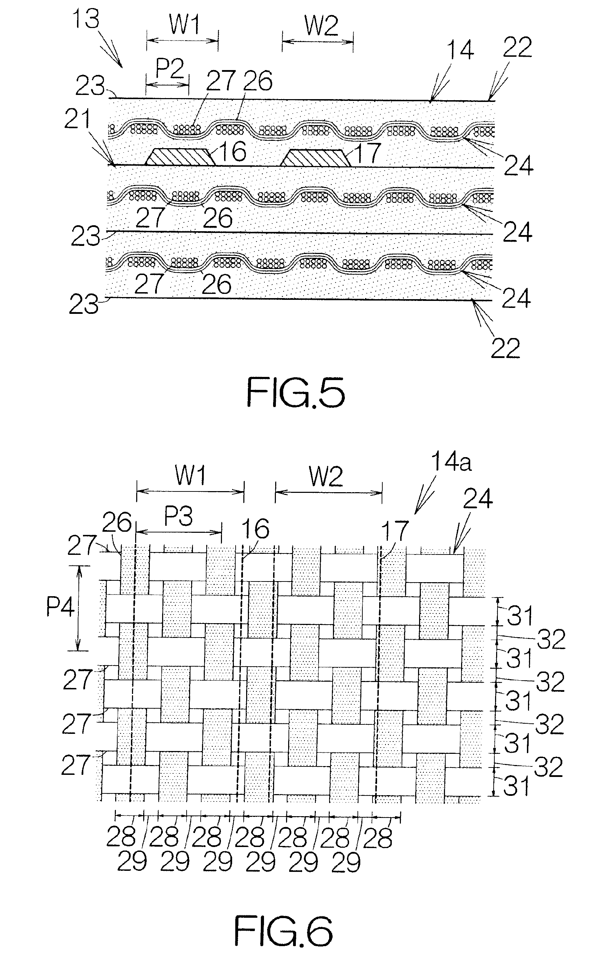

The first and second wiring patterns 16, 17 are bent at right angles. The first and second wiring patterns 16, 17 thus extend in parallel with not only the warp yarns 26 but also the weft yarns 27, as shown in Fig. 5. The width *W1* and the width *W2* are set equal to or larger than the aforementioned interval *P2*. According to the present embodiment, the interval *P2* is set at 100µm approximately, for example. The width *W1* and the width *W2* are set at 150µm approximately, for example, in the same manner as described above. Each of the first and second wiring patterns 16, 17 is in this manner reliably located in a region containing both the first and second regions 31, 32.

In the motherboard 13, the width *W1* and the width *W2* are set equal to or larger than the interval *P1*(*P2*). Each of the first and second wiring patterns 16, 17 is thus reliably located across the boundary between the first region 28 (31) and the second region 29 (32). The proportion of the glass fiber to the resin on the first wiring pattern 16 is thus equalized to the utmost to the proportion of the glass fiber to the resin on the second wiring pattern 17 with such a simplified structure. This results in a suppression of the influence resulting from a difference of the permittivity between the glass fiber and the resin on the first wiring pattern 16 and the second wiring pattern 17. A variation of characteristic impedance is reduced. A difference in transmission speed is suppressed between the first wiring pattern 16 and the second wiring pattern 17. Signals are thus transmitted with accuracy.

On the other hand, in the case where the width *W1* and the width *W2* are set smaller than the interval *P1*(*P2*), for example, the first wiring pattern 16 may be located within the first region 28 (31) while the second wiring pattern 17 may be located across the boundary between the first region 28 (31) and the second region 29(32), for example. In such a case, the first wiring pattern 16 is covered solely with the glass fiber while the second wiring pattern 17 is covered with both the glass fiber and the resin. This results in an increase of the influence resulting from a difference in the permittivity between the glass fiber and the resin. A variation of characteristic impedance is inevitable. Signals thus cannot accurately be transmitted.

Next, description will be made on a method of making the printed wiring board 14. The glass fiber cloth or cloths 24 are first interposed between the adjacent ones of prepregs. The prepregs have previously been half hardened or cured, for example. The prepregs are urged against the glass fiber cloth 24 from both the front and back sides of the glass fiber cloth 24 with a predetermined urging members, respectively. A copper foil is attached to the entire exposed surface or surfaces of the outermost one or ones of the prepregs. A heating process is applied to the prepregs so that the prepregs are completely hardened or cured. The core resin layer 21 is in this manner formed. The copper foil is then subjected to a predetermined etching process. The first and second wiring patterns 16, 17 are thus formed. The insulting layer 22 is then formed on each of the front and back surfaces of the core resin layer 21 based on the prepregs and the glass fiber cloth 24. The printed wiring board 14 is in this manner produced.

Fig. 6 schematically illustrates a printed wiring board 14a according to a second embodiment of the present invention. In the printed wiring board 14a, an interval *P3* is defined between the centerlines of the two outermost ones of adjacent three of the warp yarns 26 extending in parallel one another. The width *W1* and the width *W2* are set equal to or larger than the interval *P3*. Specifically, the interval *P3* is set equal to or larger than twice the interval *P1*. Likewise, an interval *P4* is defined between the centerlines of the two outermost ones of adjacent three of the weft yarns 27 extending in parallel one another. The width *W1* and the width *W2* are set equal to or larger than the interval *P4*. Specifically, the interval *P4* is set equal to or larger than twice the interval *P2*. The interval *P3* and the interval *P4* are set at 200µm approximately, for example. Here, the width *W1* and the width *W2* are set at 250µm approximately, for example. Like reference numerals are attached to the structure or components equivalent to those of the aforementioned printed wiring board 14.

In the printed wiring board 14a, the width *W1* and the width *W2* are set equal to or larger than the interval *P3*(*P4*). Each of the first and second wiring patterns 16, 17 is thus reliably located over a region containing at least two of the first regions 28(31) and two of the second regions 29(32). This results in a further suppression of the influence resulting from a difference in the permittivity between the glass fiber and the resin as compared with the aforementioned printed wiring board 14. A variation of characteristic impedance is further reduced. A difference in transmission speed between the first wiring pattern 16 and the second wiring pattern 17 is further suppressed. A differential signal is thus transmitted with higher accuracy.

In addition, in the printed wiring board 14a, the larger the width *W1* and the width *W2* get, the larger number of the first regions 28(31) and the second regions 29(32) are contained in a region where the first and second wiring patterns 16, 17 extend, as compared with the aforementioned printed wiring board 14. An increase in the width *W1* and the width *W2* thus results in a further suppression of the influence resulting from a difference in the permittivity between the glass fiber and the resin. A difference gets smaller in the characteristic impedance. It should be noted that an upper limit may be set for the width *W1* and the width *W2*.

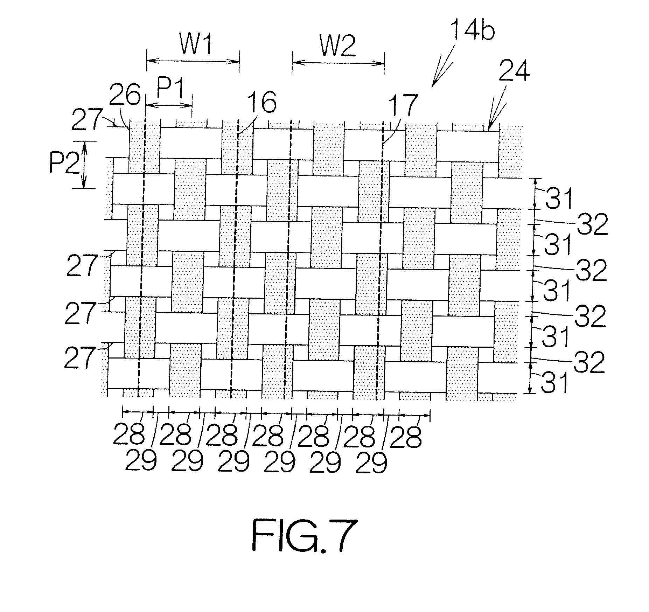

Fig. 7 schematically illustrates a printed wiring board 14b according to a third embodiment of the present invention. In the printed wiring board 14b, the width *W1* and the width *W2* are set equal to or larger than the aforementioned *P1*(*P2*) in the same manner as described above. Simultaneously, the width *W1* and the width *W2* are set equal to the integer times the interval *P1*(*P2*). Here, the width *W1* and the width *W2* are set equal to twice the interval *P1*(*P2*). Specifically, the width *W1* and the width *W2* are set at 200µm approximately. Like reference numerals are attached to the structure or components equivalent to those of the printed wiring boards 14, 14a.

In the printed wiring board 14b, when the width *W1* and the width *W2* are set equal to integer times the interval *P1 (P2)*, twice the interval *P1*(*P2*), in this case, each of the first and second wiring patterns 16, 17 is reliably located over a region containing at least a pair of the first regions 28(31) and a pair of the second regions 29 (32) irrespective of the positions of the first and second wiring patterns 16, 17 on the surface of the body 23, for example. The proportion of the glass fiber to the resin on the first wiring pattern 16 is thus completely equalized to the proportion of the glass fiber to the resin on the second wiring patterns 17. The influence of a difference in the permittivity between the glass fiber and the resin is reliably eliminated with such a simplified structure. A variation of characteristic impedance is reliably prevented. A transmission speed is reliably equalized between the first wiring pattern 16 and the second wiring pattern 17. Differential signals are thus transmitted with accuracy.

## Claims

1. A printed wiring board comprising:
a body made of resin;
woven glass fiber yarns impregnated in the resin of the body; and
an electrically-conductive wiring pattern formed on a surface of the body, the wiring pattern extending in parallel with the glass fiber yarns, wherein a width of the wiring pattern is set equal to or larger than an interval between centerlines of adjacent ones of the glass fiber yarns extending side by side.

2. The printed wiring board according to claim 1, wherein the width of the wiring pattern is set equal to or larger than an interval between centerlines of two outer ones of adjacent three of the glass fiber yarns extending side by side.

3. The printed wiring board according to claim 1, wherein the width of the wiring pattern is set equal to integer times the interval between the centerlines of adjacent ones of the glass fiber yarns.

4. A printed circuit board unit comprising:
a body made of resin;
woven glass fiber yarns impregnated in the resin of the body;
an electrically-conductive wiring pattern formed on a surface of the body, the wiring pattern extending in parallel with the glass fiber yarns; and
a pair of electronic components connected to each other through the wiring pattern, wherein
a width of the wiring pattern is set equal to or larger than an interval between centerlines of adjacent ones of the glass fiber yarns extending side by side.

5. The printed circuit board unit according to claim 4, wherein the width of the wiring pattern is set equal to or larger than an interval between centerlines of two outer ones of adjacent three of the glass fiber yarns extending side by side.

6. The printed circuit board unit according to claim 4, wherein the width of the wiring pattern is set equal to integer times the interval between the centerlines of adjacent ones of the glass fiber yarns.
